# EUROPEAN PATENT APPLICATION

(11) **EP 3 203 522 A1**
(43) Date of publication of application: **09.08.2017**
(21) Application number: 15791465.6
(22) Date of filing: 14.01.2015
(51) Int. Cl.: H01L 27/32, H01L 21/77, H01L 51/56, G03F 1/00

(54) **OLED DISPLAY SUBSTRATE, OLED DISPLAY DEVICE AND MASK PLATE**

(30) Priority: 30.09.2014 CN 201410520623
(71) Applicant: BOE Technology Group Co., Ltd., Beijing 100015 (CN); Ordos Yuansheng Optoelectronics Co., Ltd., Ordos, Inner Mongolia 017020 (CN)
(72) Inventor: JI, Fengli, Beijing 100176 (CN); XUAN, Minghua, Beijing 100176 (CN); BAI, Shanshan, Beijing 100176 (CN); LIU, Jiantao, Beijing 100176 (CN); XU, Jingbo, Beijing 100176 (CN)
(74) Representative: Cohausz & Florack
(86) International application number: PCT/CN2015/070670
(87) International publication number: WO 2016/050010

(57) **Abstract**

The present invention discloses an OLED display substrate, an OLED display device, and a mask. The OLED display substrate includes a plurality of pixel units, each of which includes a plurality of sub-pixel units arranged in horizontal direction. Each of the plurality of sub-pixel units includes a display region and a non-display region, wherein the display regions in two adjacent columns of the sub-pixel units are arranged in staggered positions. The technical solutions of the present invention effectively solve the problem of color mixture of electroluminescent layers with different colors occurring during vapor deposition of an electroluminescent material, by arranging the display regions in any two adjacent columns of the sub-pixel units in the OLED display substrate in staggered positions.

## Description

### FIELD OF THE INVENTION

The present invention relates to the field of display technology, and in particular, relates to an OLED display substrate, an OLED display device, and a mask.

### BACKGROUND OF THE INVENTION

As compared with a traditional liquid crystal display device, an active matrix organic light emitting diode (AMOLED) display device has advantages of faster response, higher contrast, wider angle of view, and the like.

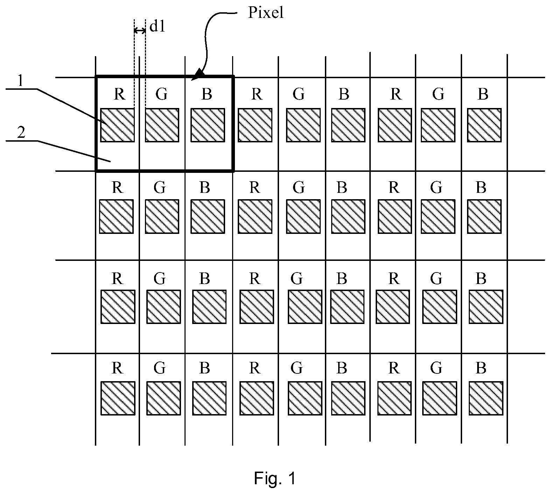

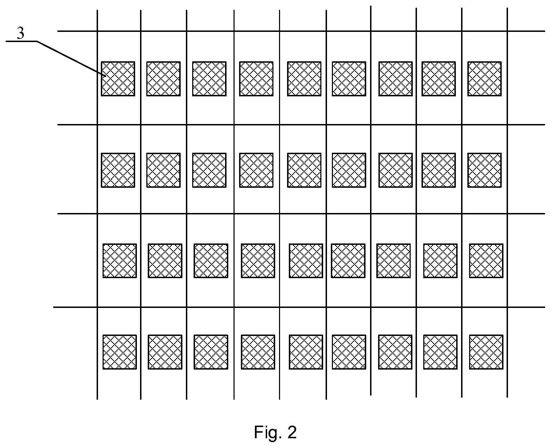

Fig. 1 is a schematic diagram showing the arrangement of sub-pixel units and display regions thereof in an OLED display substrate in the prior art, and Fig. 2 is a schematic diagram showing the arrangement of cathodes in the OLED display substrate in the prior art. As shown in Figs. 1 and 2, the OLED display substrate includes a plurality of pixel units Pixel, each of which includes a red sub-pixel unit R, a green sub-pixel unit G, and a blue sub-pixel unit B sequentially arranged in the horizontal direction, and all of the sub-pixel units in the OLED display substrate are arranged in a matrix. Each of the sub-pixel units includes a display region 1 and a non-display region 2, and the display region 1 of each sub-pixel unit is located at the center of the sub-pixel unit, that is, the display regions 1 of any two adjacent sub-pixel units in the same row are arranged side by side. A cathode 3, an anode (not shown), and an electroluminescent layer (not shown) are included in the display region 1, wherein the electroluminescent layer is located between the cathode 3 and the anode, and is used for generating predetermined color light to achieve display.

In the prior art, the electroluminescent layer may be formed on the OLED display substrate by vapor deposition. During vapor deposition, it is necessary to use a corresponding mask to pattern the electroluminescent layer. During manufacturing the OLED display substrate in the prior art, a vapor deposition process must be performed three times to form electroluminescent layers of respective colors (i.e., red, green, and blue) in the display regions 1 of sub-pixel units of respective colors, respectively.

However, a distance d1 between the display regions of two adjacent sub-pixel units in the horizontal direction in the OLED display substrate in the prior art is relatively small, and the display regions of two adjacent sub-pixel units in the same row are arranged side by side, which easily causes electroluminescent layer material, which should be located in only one sub-pixel unit, to be evaporated and deposited into the display region of another sub-pixel unit adjacent to the one sub-pixel unit in the same row. Thus, color mixture of the electroluminescent layers with two different colors occurs, which causes the another sub-pixel unit adjacent to the one sub-pixel unit in the same row unable to emit predetermined color light. Therefore, the display of a display device is affected.

### SUMMARY OF THE INVENTION

The embodiments of present invention provide an OLED display substrate, an OLED display device, and a mask, which can effectively solve the problem of color mixture of adjacent sub-pixel units in the same row occurring during vapor deposition of an electroluminescent material.

One embodiment of the present invention provides an OLED display substrate, including a plurality of pixel units, each of which including a plurality of sub-pixel units arranged in horizontal direction, wherein, each of the plurality of sub-pixel units includes a display region and a non-display region, and the display regions in two adjacent columns of the sub-pixel units are arranged in staggered positions.

Alternatively, each of the plurality of pixel units includes a red sub-pixel unit, a green sub-pixel unit, and a blue sub-pixel unit arranged in a predetermined order in the horizontal direction.

Alternatively, the display region of the red sub-pixel unit, the display region of the green sub-pixel unit, and the display region of the blue sub-pixel unit in each of the plurality of pixel units are arranged in a triangle or an inverted triangle.

Alternatively, the display regions of the sub-pixel units corresponding to a same color in two adjacent pixel units in a same row are arranged in staggered positions.

Alternatively, all of the sub-pixel units in a same column are sub-pixel units with same color.

Alternatively, an area of the display region of the blue sub-pixel unit is larger than an area of the display region of the red sub-pixel unit; and

the area of the display region of the red sub-pixel unit is larger than that of the display region of the green sub-pixel unit.

Alternatively, a shape of the display region is a rectangle.

One embodiment of the present invention further provides an OLED display device including an OLED display substrate, wherein the OLED display substrate is any one of the above OLED display substrates.

One embodiment of the present invention further provides a mask, which is configured to manufacture the sub-pixel units with same color in any one of the above OLED display substrates during a vapor deposition process.

Alternatively, a shape of an opening region in the mask is a rectangle.

An advantageous technical effect of the present invention is as follows.

In the OLED display substrate, the OLED display device, and the mask provided by the present invention, the problem of color mixture of electroluminescent layers with different colors occurring during vapor deposition of an electroluminescent material is effectively solved by arranging the display regions in any two adjacent columns of the sub-pixel units in the OLED display substrate in staggered positions.

### BRIEF DESCRIPTION OF THE DRAWINGS

Fig. 1 is a schematic diagram showing the arrangement of sub-pixel units and display regions thereof in an OLED display substrate in the prior art;
Fig. 2 is a schematic diagram showing the arrangement of cathodes in the OLED display substrate in the prior art;
Fig. 3 is a schematic diagram showing the arrangement of sub-pixel units and display regions thereof in an OLED display substrate provided by a first embodiment of the present invention;
Fig. 4 is a schematic diagram showing the arrangement of cathodes in the OLED display substrate provided by the first embodiment of the present invention;
Fig. 5 is a schematic diagram showing a mask for manufacturing the electroluminescent layers in the red sub-pixel units in the OLED display substrate in the prior art; and
Fig. 6 is a schematic diagram showing a mask for manufacturing the electroluminescent layers in the red sub-pixel units in the OLED display substrate provided by the first embodiment of the present invention.

### DETAILED DESCRIPTION OF THE EMBODIMENTS

For better understanding the technical solutions of the present invention by a person skilled in the art, an OLED display substrate, an OLED display device, and a mask provided by the present invention will be described in detail with reference to the drawings.

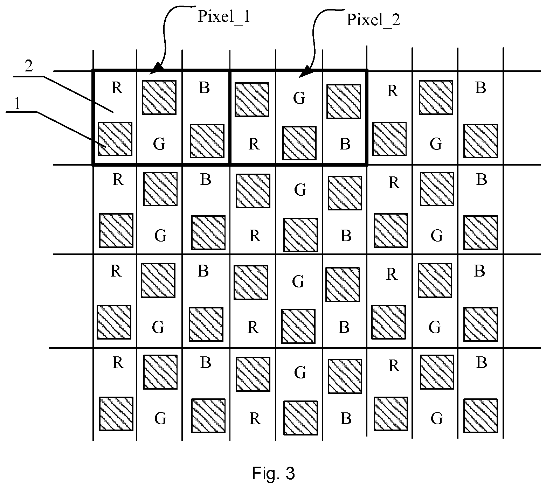

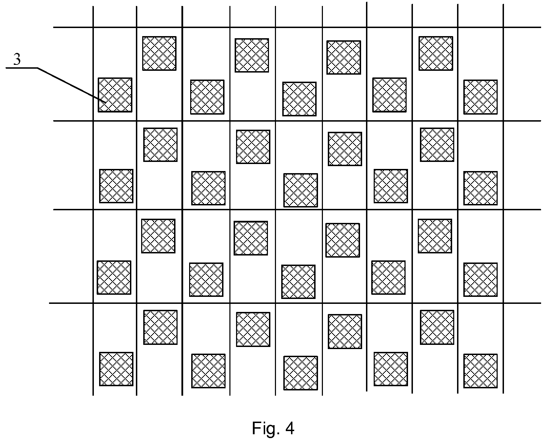

Fig. 3 is a schematic diagram showing the arrangement of sub-pixel units and display regions thereof in an OLED display substrate provided by a first embodiment of the present invention, and Fig. 4 is a schematic diagram showing the arrangement of cathodes in the OLED display substrate provided by the first embodiment of the present invention. As shown in Figs. 3 and 4, the OLED display substrate includes a plurality of pixel units, each of which includes a plurality of sub-pixel units arranged in the horizontal direction. Each of the plurality of sub-pixel units includes a display region 1 and a non-display region 2, wherein all of the sub-pixel units in the OLED display substrate are arranged in a matrix, and the display regions 1 in two adjacent columns of the sub-pixel units are arranged in staggered positions. Correspondingly, cathodes 3 (and anodes) in any two adjacent columns in the OLED display substrate are arranged in staggered positions.

In the present embodiment, since the display regions 1 in any two adjacent columns of the sub-pixel units are arranged in staggered positions, even if a case where electroluminescent layer material, which should be located in only one sub-pixel unit, is evaporated and deposited into another sub-pixel unit adjacent to the one sub-pixel unit in the same row occurs during vapor deposition, the material falling into the another sub-pixel unit adjacent to the one sub-pixel unit in the same row will fall into only the non-display region 2 of the another sub-pixel unit adjacent to the one sub-pixel unit in the same row. Thus, a phenomenon of color mixture will not occur in the display region 1 of the another sub-pixel unit adjacent to the one sub-pixel unit in the same row.

Based on the above inventive concept, in the present embodiment, a size of the display region 1 in each of the sub-pixel units may be enlarged in the horizontal direction (i.e., a row direction), that is, an area of the display region 1 in each of the sub-pixel units may be increased accordingly, thereby increasing an aperture ratio of each of the sub-pixel units effectively.

As a specific implementation of the present embodiment, each of the pixel units includes a red sub-pixel unit R, a green sub-pixel unit G, and a blue sub-pixel unit B arranged in a predetermined order in the horizontal direction. Further, all of the sub-pixel units in a same column in the OLED display substrate correspond to a same color. That is, in Fig. 3, all of the sub-pixel units in a first column are red sub-pixel units R, all of the sub-pixel units in a second column are green sub-pixel units G, and all of the sub-pixel units in a third column are blue sub-pixel units B, and such arrangement is repeated.

Description will be made by taking a case where the display region 1 in each of the red sub-pixel units R in the first column is located in the lower half region of the red sub-pixel unit R as an example.

The display region 1 in each of the red sub-pixel units R in the first column is located in the lower half region of the red sub-pixel unit R, and the display regions 1 in two adjacent columns of the sub-pixel units are arranged in staggered positions, thus, the display region 1 in each of the green sub-pixel units G in the second column is located in the upper half region of the green sub-pixel unit G, the display region 1 in each of the blue sub-pixel units B in the third column is located in the lower half region of the blue sub-pixel unit B, the display region 1 in each of the red sub-pixel units R in a fourth column is located in the upper half region of the red sub-pixel unit R, the display region 1 in each of the green sub-pixel units G in a fifth column is located in the lower half region of the green sub-pixel unit G, and the display region 1 in each of the blue sub-pixel units B in a sixth column is located in the upper half region of the blue sub-pixel unit B, every six columns being a cycle and sub-pixel units in other columns being arranged in such a way.

In the OLED display substrate provided by the present embodiment, there are two kinds of pixel units with different structure, which are a first pixel unit Pixel_1 and a second pixel unit Pixel_2, respectively. In the first pixel unit Pixel_1, the display region 1 of the red sub-pixel unit R, the display region 1 of the green sub-pixel unit G, and the display region 1 of the blue sub-pixel unit B are arranged in a triangle. In the second pixel unit Pixel_2, the display region 1 of the red sub-pixel unit R, the display region 1 of the green sub-pixel unit G, and the display region 1 of the blue sub-pixel unit B are arranged in an inverted triangle. The above expression of "being arranged in a triangle" refers to that, a line sequentially connecting the centers of the display regions 1 of the three sub-pixel units in the pixel unit forms a triangle of which the base side is located at the bottom. The above expression of "being arranged in an inverted triangle" refers to that, a line sequentially connecting the centers of the display regions 1 of the three sub-pixel units in the pixel unit forms a triangle of which the base side is located at the top. The base side may be substantially parallel to the horizontal direction. The first pixel unit Pixel_1 and the second pixel unit Pixel-2 are alternately arranged in the horizontal direction, and the display regions 1 of the sub-pixel units corresponding to a same color in the first pixel unit Pixel_1 and the second pixel unit Pixel_2 are arranged in staggered positions.

In the present embodiment, the display regions 1 of the sub-pixel units corresponding to a same color (i.e., two sub-pixel units with a same color) in two adjacent pixel units (e.g., the first pixel unit Pixel_1 and the second pixel unit Pixel_2) in a same row are arranged in staggered positions, which can increase the strength of a corresponding mask effectively. Description will be made by taking a mask configured to manufacture electroluminescent layers in the red sub-pixel units R as an example.

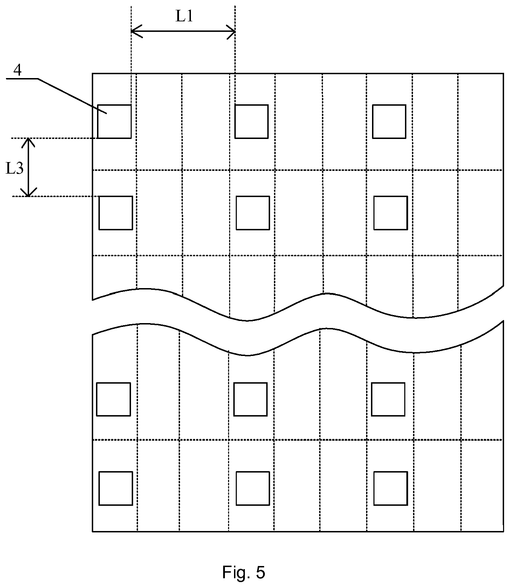

Fig. 5 is a schematic diagram showing a mask for manufacturing electroluminescent layers in the red sub-pixel units R in the OLED display substrate in the prior art. As shown in Fig. 5, in the mask for manufacturing electroluminescent layers in the red sub-pixel units R in the OLED display substrate in the prior art, a distance between two adjacent opening regions 4 in the horizontal direction is L1, the amount of the distance L1 being approximately equal to a width of two sub-pixel units in the horizontal direction, and a distance between two adjacent opening regions 4 in the vertical direction is L3, the amount of the distance L3 being dependent on a manufacturing process of the mask and generally being a fixed value.

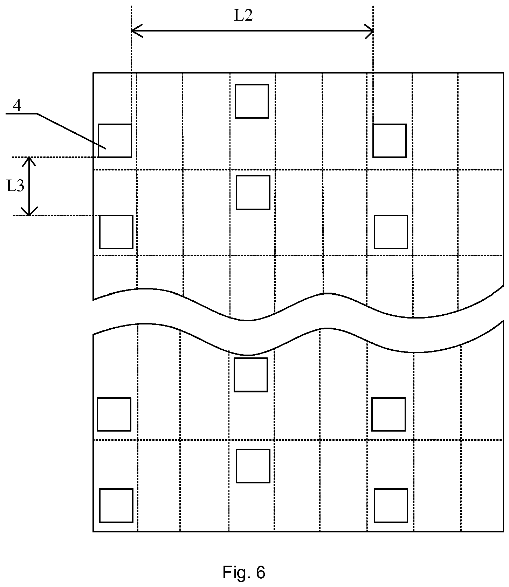

Fig. 6 is a schematic diagram showing a mask for manufacturing electroluminescent layers in the red sub-pixel units R in the OLED display substrate provided by the first embodiment of the present invention. As shown in Fig. 6, in the mask for manufacturing electroluminescent layers in the red sub-pixel units R in the OLED display substrate provided by the first embodiment of the present invention, a distance between two adjacent opening regions 4 in the horizontal direction is L2, the amount of the distance L2 being approximately equal to a width of five sub-pixel units in the horizontal direction, thus it can be seen that L2>L1; and a distance between two adjacent opening regions 4 in the vertical direction is L3 (which is the same as that in the prior art). It can be seen that, as compared with the prior art, the present invention can effectively increase a distance between two adjacent opening regions 4 in the mask in the horizontal direction in a case where the resolution of the OLED display substrate remains unchanged. In the present embodiment, since a distance between two adjacent opening regions 4 in the horizontal direction is increased, the strength of the mask is increased.

In the present embodiment, alternatively, a shape of the display region 1 in each of the sub-pixel units is a rectangle. In this case, a shape of each of the opening regions 4 in the corresponding mask is also a rectangle. In the present embodiment, the shape of each of the opening regions 4 in the mask is provided as a rectangle, which can greatly reduce the difficulty of making the mask. It should be noted that, the case where the shape of the display region 1 in each of the sub-pixel units is a rectangle in the present embodiment is only a preferred embodiment of the present invention, and the technical solutions of the present invention are not limited thereto. A shape of each of the display regions 1 in the present invention may be another shape, and detailed description thereof is omitted herein.

Masks for manufacturing electroluminescent layers in the green sub-pixel units G and those in the blue sub-pixel units B are similar to the mask for manufacturing electroluminescent layers in the red sub-pixel units R, and detailed description thereof is omitted herein.

In the present embodiment, alternatively, the display region 1 in each of the sub-pixel units may be enlarged in the horizontal direction (i.e. a row direction), so that the areas of the enlarged display regions 1 in the sub-pixel units satisfy the following relationship: the area of the display region 1 of the blue sub-pixel unit B is larger than that of the display region 1 of the red sub-pixel unit R; and the area of the display region 1 of the red sub-pixel unit R is larger than that of the display region 1 of the green sub-pixel unit G.

In a practical production, the luminous efficiency and service life of an electroluminescent material for emitting blue light are less than those of an electroluminescent material for emitting red light respectively, and the luminous efficiency and service life of the electroluminescent material for emitting red light are less than those of an electroluminescent material for emitting green light respectively. Thus, the service life of an entire OLED display device mainly depends on the service life of the electroluminescent material for emitting blue light. When the area of the display region 1 in each of the blue sub-pixel units B is increased, the luminous intensity of the electroluminescent material for emitting blue light in each of the blue sub-pixel units B may be decreased correspondingly. In this case, the density of current passing through the electroluminescent material may be decreased accordingly, thus the service life of the electroluminescent material for emitting blue light can be extended, that is, the service life of an OLED display device is extended.

Based on the above principle, the present embodiment can balance the service lives of the electroluminescent materials in the red sub-pixel unit R, the green sub-pixel unit G, and the blue sub-pixel unit B, by setting the area of the display region 1 of the blue sub-pixel unit B to being larger than that of the display region 1 of the red sub-pixel unit R and setting the area of the display region 1 of the red sub-pixel unit R to being larger than that of the display region 1 of the green sub-pixel unit G.

Of course, the above definition to the display region 1 in each of the sub-pixel units is only a preferred implementation of the present embodiment, and the technical solutions of the present invention are not limited thereto.

As described above, the first embodiment of the present invention provides an OLED display substrate. The OLED display substrate includes a plurality of pixel units, each of which includes a plurality of sub-pixel units arranged in the horizontal direction. Each of the plurality of sub-pixel units includes a display region and a non-display region, wherein the display regions in two adjacent columns of the sub-pixel units in the OLED display substrate are arranged in staggered positions. The technical solutions of the present invention effectively solve the problem of color mixture of electroluminescent layers with different colors occurring during vapor deposition of an electroluminescent material, by arranging the display regions in two adjacent columns of the sub-pixel units in the OLED display substrate in staggered positions.

A second embodiment of the present invention provides an OLED display device including an OLED display substrate, wherein the OLED display substrate is the OLED display substrate provided by the first embodiment. The specific configuration of the OLED display substrate may be referred to the description for the first embodiment, and detailed description thereof is omitted herein. Since the OLED display device provided by the second embodiment of the present invention includes the OLED display substrates provided by the first embodiment, the OLED display device provided by the present embodiment of the present invention can achieve at least all of the advantageous effects of the first embodiment.

A third embodiment of the present invention provides a mask, which is configured to perform masking when the sub-pixel units with same color in the OLED display substrate provided by the first embodiment are manufactured by a vapor deposition process. Obviously, the arrangement of the opening regions of the mask corresponds to the arrangement of the sub-pixel units with same color in the OLED display substrate of the first embodiment. It can be seen from the description for the first embodiment that, as compared with the prior art, the mask provided by the third embodiment of the present invention has a higher strength and a better practicability.

Further, in the present embodiment, the shape of each of the opening regions in the mask is provided as a rectangle, which can greatly reduce the difficulty of making the mask.

It should be understood that, the above embodiments are only exemplary embodiments for the purpose of explaining the principle of the present invention, and the present invention is not limited thereto. For a person skilled in the art, various improvements and modifications may be applied to the present invention without departing from the spirit and essence of the present invention. These improvements and modifications also fall within the protection scope of the present invention.

## Claims

1. An OLED display substrate, including a plurality of pixel units, each of which including a plurality of sub-pixel units arranged in horizontal direction, wherein, each of the plurality of sub-pixel units includes a display region and a non-display region, and the display regions in two adjacent columns of the sub-pixel units are arranged in staggered positions.

2. The OLED display substrate according to claim 1, wherein, each of the plurality of pixel units includes a red sub-pixel unit, a green sub-pixel unit, and a blue sub-pixel unit arranged in a predetermined order in the horizontal direction.

3. The OLED display substrate according to claim 2, wherein, the display region of the red sub-pixel unit, the display region of the green sub-pixel unit, and the display region of the blue sub-pixel unit in each of the plurality of pixel units are arranged in a triangle or an inverted triangle.

4. The OLED display substrate according to claim 2, wherein, the display regions of the sub-pixel units corresponding to a same color in two adjacent pixel units in a same row are arranged in staggered positions.

5. The OLED display substrate according to claim 2, wherein, all of the sub-pixel units in a same column are sub-pixel units with same color.

6. The OLED display substrate according to claim 2, wherein, an area of the display region of the blue sub-pixel unit is larger than an area of the display region of the red sub-pixel unit; and
the area of the display region of the red sub-pixel unit is larger than that of the display region of the green sub-pixel unit.

7. The OLED display substrate according to any one of claims 1 to 6, wherein, a shape of the display region is a rectangle.

8. An OLED display device, including the OLED display substrate according to any one of claims 1 to 7.

9. A mask, configured to manufacture the sub-pixel units with same color in the OLED display substrate according to any one of claims 1 to 7 during a vapor deposition process.

10. The mask according to claim 9, wherein, a shape of an opening region in the mask is a rectangle.
